# EUROPÄISCHE PATENTSCHRIFT

(11) **EP 0 972 485 B1**
(45) Veröffentlichungstag und Bekanntmachung des Hinweises auf die Patenterteilung: **20.07.2005**
(21) Anmeldenummer: 99110198.1
(22) Anmeldetag: 26.05.1999
(51) Int. Cl.: A47L 15/42, C23C 14/00

(54) **Bedienblendeneinheit für elektrisch betriebene Haushaltsgeräte**
Control panel for electrical household devices
Panneau de commande pour appareils ménagers à entraînement électrique

(30) Priorität: 16.07.1998 DE 19831849
(43) Veröffentlichungstag der Anmeldung: 19.01.2000
(73) Patentinhaber: AEG Hausgeräte GmbH, 90429 Nürnberg (DE)
(72) Erfinder: Kraft, Max, 90614 Ammerndorf (DE); Gerngross, Albert, 91161 Hilpolstein (DE)

(56) Entgegenhaltungen:
- DE-A- 3 821 131
- DE-A- 4 015 170
- DE-A- 4 104 198
- GB-A- 2 188 830

## Beschreibung

Die Erfindung betrifft eine Bedienblendeneinheit nach dem Oberbegriff des Patentanspruches 1. Eine solche Einheit ist aus der Druckschrift GB-A-2 188 830 zu entnehmen.

Eine allgemein bekannte Bedienblendeneinheit der in Rede stehenden Art besteht aus einem rahmenartigen Kunststoff-Blendenkörper, an dessen Rückseite elektrische Steuer- und Anzeigekomponenten gehaltert sind. Die Frontseite der Bedienblendeneinheit, in der die Bedienelemente für die Steuerkomponenten integriert sind, ist durch einen aus hochwertigem Kunststoff hergestellten Blendeneinleger abgedeckt, der für die Bedienungsperson Bedienungshinweise in Form von grafischen Darstellungen und/oder Beschriftungen aufweist. Die Herstellung dieses Blendeneinlegers ist besonders kostenintensiv und wird durch den aufwendigen Klebevorgang zum Fixieren des Blendeneinlegers auf dem Blendenträger weiter verteuert.

Weiterhin ist eine Bedienblendeneinheit für eine Geschirrspülmaschine bekannt geworden, die ebenfalls aus einem rahmenartigen Kunststoff-Blendenkörper besteht. Die äußere Kontur dieses Kunststoff-Blendenkörpers ist dabei durch eine Haube aus Edelstahl über- bzw. vollständig abgedeckt. Eine solcherart hergetellte Bedienblendeneinheit ist besonders teuer und ist deshalb an sich nur für im oberen Preissegment angesiedelte Geschirrspülmaschine einsetzbar. Für eine preiswerte Massenfertigung ist eine solche Bedienblendeneinheit somit nicht geeignet. Des weiteren ist bei dieser bekannten Bedienblendeneinheit der Materialeinsatz ebenfalls beträchtlich, wodurch diese Einheit auch besonders schwer wird.

Der Erfindung liegt deshalb die Aufgabe zugrunde, eine Bedienblendeneinheit zu schaffen, die materialsparend aufgebaut und besonders zur Herstellung als preiswerter Massenartikel geeignet ist.

Die Lösung dieser Aufgabe gemäß der Erfindung ist dem kennzeichnenden Teil des Patentanspruches 1 zu entnehmen. Vorteilhafte weitere Ausgestaltungen des Gegenstandes der Erfindung sind in den Unteransprüchen angegeben.

Die vorgeschlagene Bedienblendeneinheit für Haushaltsgeräte kann kostensparend hergestellt werden und ist deshalb aufgrund ihres niedrigen Kostenniveaus auch für Geräte der unteren Preisklasse mit Vorteil einsetzbar.

Ein Ausführungsbeispiel der Erfindung ist in der Zeichnung dargestellt und wird anhand dieser nachfolgend näher beschrieben.

Es zeigen:
- Figur 1: eine Geschirrspülmaschine mit frontseitiger Tür, die eine Bedienblendeneinheit trägt,
- Figur 2: einen Schnitt durch eine vergrößert dargestellte Bedienblendeneinheit.

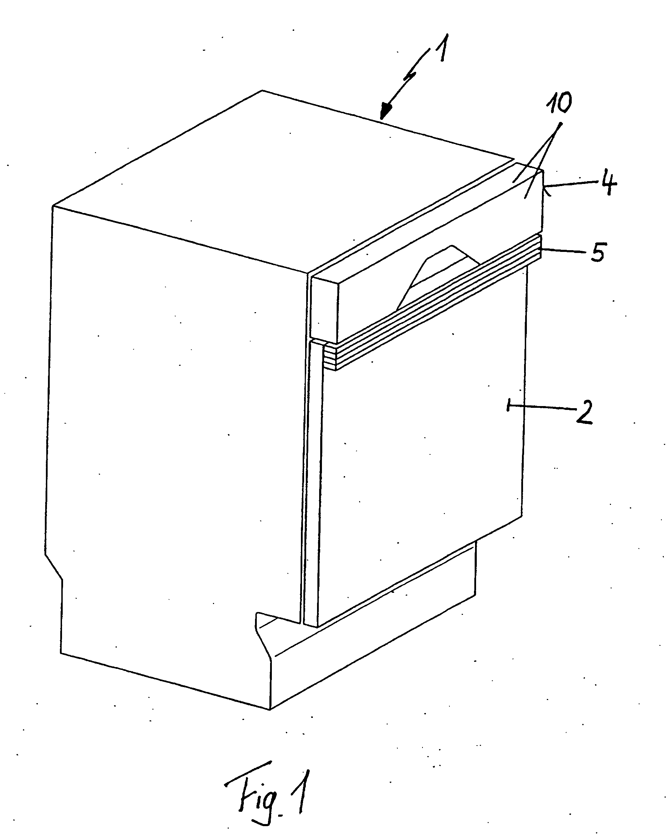

Die in Figur 1 der Zeichnung als bevorzugtes Ausführungsbeispiel dargestellte Geschirrspülmaschine 1 weist frontseitig eine Tür 2 und eine Bedienblendeneinheit 4 auf, entlang deren unterer Randzone leistenförmige Lamellen 5 zum Ausgleich einer Differenz zwischen der Bedienblendeneinheit 4 und einer nicht dargestellten Möbelverkleidungsplatte angeordnet sind.

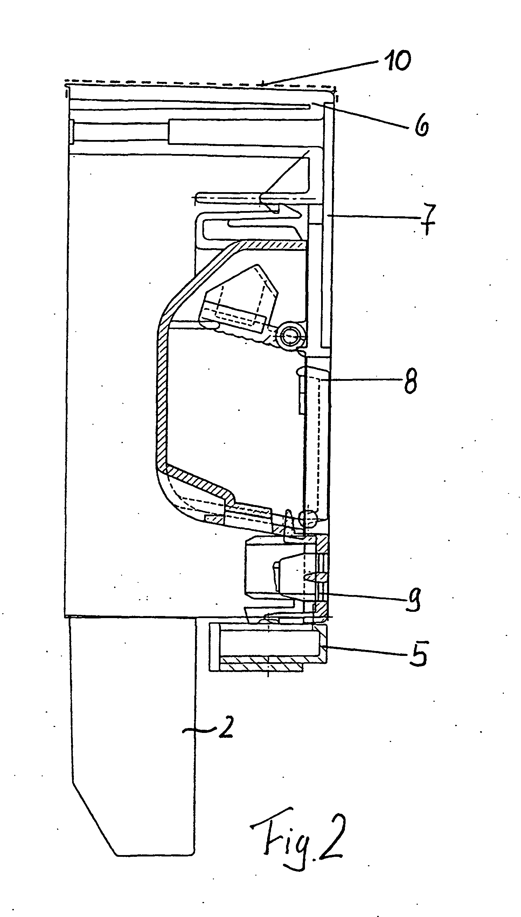

Die Bedienblendeneinheit 4 nach Figur 2 besteht aus einem rahmenartigen Kunststoff-Blendenkörper 6 (Blendenträger), dessen Frontseite durch einen aufsetzbaren bzw. einlegbaren bedruckten Blendeneinleger 7 vollständig abgedeckt ist. Es wäre auch denkbar, die Bedienblendeneinheit ohne Blendeneinleger, d.h. als einstückige Einheit (Blendenkörper) herzustellen. Der Bedienblendeneinheit 4 sind weitere Funktionsbestandteile, wie z.B. Türgriffklappe 8, Ausblasgitter 9 und aus der Zeichnung nicht ersichtliche Bedienelemente (z.B. Drucktasten) für Steuerkomponenten zugeordnet bzw. in dieser integriert.

Auf dem Blendenkörper, und zwar vorzugsweise auf dessen sichtbaren Konturen, ist ein metallischer Überzug bzw. eine MetallBeschichtung 10 aufgebracht, wobei der Überzug bzw. die Beschichtung zweckmäßig aus Nickel oder auch Chrom bestehen kann. Um der Bedienblendeneinheit 4 ein optisch gefälliges Aussehen zu geben ist es zweckmäßig, auch die übrigen sichtbaren Funktionsbestandteile, wie Türgriffklappe 8, Ausblasgitter 9, Bedienelemente und auch die leistenförmigen Höhenausgleichslamellen 5 mit einem solchen metallischen Überzug zu versehen. Falls der Blendeneinleger 7 nicht selbst aus einer der beschichteten Bedienblendeneinheit 4 optimal angepaßten Metallplatte sondern z.B. aus einer Kunststoffplatte besteht, wird auch diese mit dem entsprechenden metallischen Überzeug beschichtet und damit dem Blendenkörper 6 optisch angepaßt.

Die Herstellung des metallischen Überzuges bzw. der Beschichtung 10 kann galvanisch oder durch Bedampfen erfolgen.

Der metallbeschichtete Blendeneinleger bzw. die Frontseite des metallbeschichteten einstückigen Kunststoff-Blendenkörpers können mit den üblichen grafischen Darstellungen und/oder Beschriftungen als Bedienungshilfe ohne Schwierigkeiten bedruckt werden.

## Patentansprüche

1. Bedienblendeneinheit für elektrisch betriebene Haushaltsgeräte, insbesondere für Geschirrspülmaschinen, bestehend aus einem rahmenartigen Kunststoff-Blendenkörper (6) für die Aufnahme von Bedien- und Anzeigeelementen oder aus einem rahmenartigen Kunststoff-Blendenkörper (6) und einem Kunststoff-Blendeneinleger (7), **dadurch gekennzeichnet, dass** auf dem Kunststoff-Blendenkörper (6) und/oder auf dem Kunststoff-Blendeneinleger (7) ein metallischer Überzug bzw. eine Metallbeschichtung (10) aufgebracht ist.

2. Bedienblendeneinheit nach Anspruch 1, **dadurch gekennzeichnet, dass** die Bedienelemente und gegebenenfalls weitere der Bedienblende (4) zugeordnete Bestandteile wie Griffklappe (8), Lüftungsgitter (9), Höhenausgleichsleisten (5) und dergleichen mit einem metallischen Überzug beziehungsweise einer Metallbeschichtung versehen sind.

3. Bedienblendeneinheit nach Anspruch 1, **dadurch gekennzeichnet, dass** der Überzug beziehungsweise die Beschichtung (10) galvanisch oder durch Bedampfen herstellbar ist.

4. Bedienblendeneinheit nach Anspruch 1 oder einem der folgenden, **dadurch gekennzeichnet, dass** der Überzug beziehungsweise die Beschichtung (10) aus Nickel, Chrom oder dergleichen besteht.

5. Bedienblendeneinheit nach Anspruch 1 oder einem der folgenden, **dadurch gekennzeichnet, dass** die Frontseite des beschichteten Blendenkörpers (6) beziehungsweise der beschichtete Blendeneinleger (7) mit grafischen Darstellungen und/oder Beschriftungen bedruckt ist.

## Claims

1. Operating screen unit for electrically operated domestic appliances, in particular for dishwashers, consisting of a frame-like plastics screen body (6) for receiving operating and display elements or of a frame-like plastics screen body (6) and a plastics screen loader (7), **characterised in that** over the plastics screen body (6) and/or over the plastics screen loader (7) a metal covering or metal coating (10) is applied.

2. Operating screen unit according to claim 1, **characterised in that** the operating elements and optionally further components allocated to the operating screen (4) such as handle flap (8), ventilation grid (9), height-adjusting strips (5) and the like are provided with a metal covering or metal coating.

3. Operating screen unit according to claim 1, **characterised in that** the covering or coating (10) may be produced galvanically or by vapour-plating.

4. Operating screen unit according to claim 1 or one of the subsequent claims, **characterised in that** the covering or coating (10) consists of nickel, chromium or the like.

5. Operating screen unit according to claim 1 or one of the subsequent claims, **characterised in that** the front face of the coated screen body (6) or of the coated screen loader (7) is imprinted with graphic images and/or writing.

## Revendications

1. Unité de panneau de commande pour des appareils ménagers à entraînement électrique, en particulier pour des lave-vaisselle, constituée d'un corps de panneau en matériau synthétique en forme de cadre (6) pour la réception d'éléments de commande et d'affichage ou d'un corps de panneau en matériau synthétique en forme de cadre (6) et d'un insert de panneau en matériau synthétique (7), **caractérisée en ce qu'**une couverture métallique respectivement une couche de revêtement métallique (10) est appliquée au corps de panneau en matériau synthétique (6) et/ou à l'insert de panneau en matériau synthétique (7).

2. Unité de panneau de commande selon la revendication 1, **caractérisée en ce que** les éléments de commande et le cas échéant d'autres composants associés au panneau de commande (4), comme le volet de poignée (8), la grille d'aération (9), des baguettes d'égalisation en hauteur (5) et analogues sont pourvus d'une couverture métallique respectivement d'une couche de revêtement métallique.

3. Unité de panneau de commande selon la revendication 1, **caractérisée en ce que** la couverture respectivement le revêtement (10) peut être fabriquée par galvanisation ou par métallisation au vide.

4. Unité de panneau de commande selon la revendication 1 ou l'une des suivantes, **caractérisée en ce que** la couverture respectivement le revêtement (10) est constituée de nickel, de chrome ou analogue.

5. Unité de panneau de commande selon la revendication 1 ou l'une des suivantes, **caractérisée en ce que** le côté frontal du corps de panneau revêtu (6) respectivement de l'insert de panneau revêtu (7) est imprimé avec des représentations graphiques et/ou des inscriptions.
